Europäisches Patentamt

European Patent Office

Office européen des brevets

(11) Numéro de publication: **0 200 651**

**B1**

(12) **FASCICULE DE BREVET EUROPEEN**

(45) Date de publication du fascicule du brevet: **30.05.90**

(51) Int. Cl.⁵: **H 01 J 27/16**

(21) Numéro de dépôt: **86400931.1**

(22) Date de dépôt: **28.04.86**

(54) **Source d'ions du type triode à une seule chambre d'ionisation à excitation haute fréquence et à confinement magnétique du type multipolaire.**

(30) Priorité: **29.04.85 FR 8506492**

(43) Date de publication de la demande:
**05.11.86 Bulletin 86/45**

(45) Mention de la délivrance du brevet:
**30.05.90 Bulletin 90/22**

(84) Etats contractants désignés:
**DE GB**

(56) Documents cités:
**DE-A-3 134 337**
**FR-A-2 550 681**
**US-A-4 481 062**

**APPLIED PHYSICS LETTERS, vol. 45, no. 2, 15 juillet 1984, pages 132-134, American Institute of Physics, New York, US; Y. ARNAL et al.: "Plasma etching in magnetic multipole microwave discharge"**

(73) Titulaire: **CENTRE NATIONAL DE LA RECHERCHE SCIENTIFIQUE (CNRS)**
**15, Quai Anatole France**
**F-75700 Paris Cedex 07 (FR)**

(72) Inventeur: **Lejeune, Claude**
**61, rue Vatolle**
**F-91190 Gif sur Yvette (FR)**

(74) Mandataire: **Lecca, Jean et al**
**CABINET PLASSERAUD 84, rue d'Amsterdam**
**F-75009 Paris (FR)**

(56) References cited:
**IBM TECHNICAL DISCLOSURE BULLETIN, vol. 24, no. 11B, avril 1982, pages 5833-5835, IBM Corp., New York, US; C.R. GUARNIERI et al.: "RF ion source"**

Courier Press, Leamington Spa, England.

**Description**

La présente invention est relative aux sources d'ions à une seule chambre d'ionisation dans laquelle le plasma est créé par excitation d'un gaz à l'aide d'un champ électrique de haute fréquence, pour la formation soit de plasmas, soit de faisceaux d'ions.

De telles sources d'ions s'avèrent être de plus en plus demandées, d'une part, pour les traitements mécaniques de surface des matériaux, en vue de leur impartir une résistance accrue à la corrosion et à l'usure, et, d'autre part, pour leur application dans les phases de fabrication des circuits intégrés à haut niveau d'intégration, par exemple pour le nettoyage des substrats, le dépôt de couches minces (par épitaxie ou pour réaliser des couches de passivation), le strippage des résines et la gravure des motifs.

L'invention vise à réaliser une source d'ions permettant d'obtenir des faisceaux de large section, uniformes sur la quasi-totalité de leur section et stables dans le temps, à partir de gaz chimiquement réactifs soit sur les matériaux de la décharge, soit entre eux.

Elle vise à assurer un compromis satisfaisant entre les différentes exigences pour de telles sources, telles que longue durée de vie, faible pollution, rendement ou degré d'ionisation élevé, simplicité de mise en oeuvre et d'automatisation, reproductibilité.

Des sources d'ions à une chambre d'ionisation sont connues dans la technique.

A) On connaît en particulier des sources d'ions à une chambre d'ionisation dont le plasma est créé par excitation haute fréquence à l'aide d'un champ électrique alternatif appliqué entre deux électrodes se faisant vis-à-vis et de formes diverses (plane, cylindrique ou sphérique), selon le type diode haute fréquence à couplage capacitif.

Cette structure est largement exploitée actuellement en technologie plasma par suite de sa simplicité et du fait qu'elle convient bien pour l'ionisation de gaz réactifs, sans problème de durée de vie, mais en revanche elle présente des lacunes en ce qui concerne l'uniformité du plasma, la pollution d'une cible, portée par l'anode, consécutive à la pulvérisation de la cathode sous l'impact des ions, le degré d'ionisation du plasma, la pression limite d'opération, car le rendement d'ionisation est très faible, et le contrôle de l'énergie des ions arrivant sur l'une ou l'autre des électrodes, toutes les deux participant à la création du plasma et n'ayant en conséquence pas de degré de liberté quant à leur polarisation.

Certaines améliorations ont été obtenues par l'application d'un champ magnétique (axial ou transverse), mais au préjudice de l'uniformité, et par la mise en oeuvre d'un circuit de polarisation indépendant à fréquence différente sur la seconde électrode.

De telles diodes haute fréquence à couplage capacitif sont décrites par exemple dans le livre de synthèse de Brian Chapman "Glow Discharge Processes" 1980, John Wiley and Son, New York.

B) On connaît par ailleurs des sources d'ions à une chambre d'ionisation dont le plasma est créé par l'application d'un champ électrique continu statique entre un filament chaud émetteur d'électrons et une anode constituant les parois de la chambre, à la périphérie de laquelle un confinement magnétique du type multimiroir est réalisé par des pôles magnétiques alternés qui donnent une structure de diode multipolaire à courant continu.

Ces sources donnent un plasma dense, uniforme et calme sur de larges sections dans de bonnes conditions de simplicité, de reproductibilité et de rendement; par contre le fonctionnement avec des gaz réactifs s'avère pratiquement impossible, tant par suite de la vulnérabilité du filament chaud, vis-à-vis de l'oxygène en particulier, que par suite des conséquences d'éventuels dépôts, dans la chambre, de gaz composés (fluorés ou chlorés), l'opération avec des gaz composés du type fluorocarbone entraînant par exemple l'extinction de la décharge continue après seulement quelques heures de fonctionnement, au cours desquelles une dérive permanente du point de fonctionnement est observée. De plus des pollutions des cibles se produisent du fait de l'évaporation, de la pulvérisation et de l'éventuelle attaque chimique du filament chaud.

Une source d'ionisation de ce type est décrite dans un article de T.D. Mantei et T. Wicker, Appl. Phys. Letters, 43 (1983) 84 et les articles de H.R. Kaufman, J. of Vac. Sc. Technol., 1978, vol. 15, p. 272 et H.R. Kaufman et al, J. of Vac Sc. Technol., 1982, vol. 21, p. 725.

C) On connaît également des sources d'ions à une seule chambre d'ionisation dans lesquelles le confinement magnétique multimiroir est associé à l'ionisation ou excitation des neutres par un champ électrique alternatif soit de haute fréquence, soit de très haute fréquence de façon à associer les avantages et à réduire les inconvénients qui peuvent résulter des structures mentionnées ci-dessus sous A et B.

De telles sources sont décrites par exemple dans les articles suivants:

—E.R. Ault et K.R. MacKenzie, Rev. Sci. Instrum., 44 (1983) 1967,

—Fosnight et al, EDB 700205 TRW, Redondo Beach, Ca. (U.S.A.), 1982,

—Y. Arnal et al, Appl. Phys. Lett., vol. 45 (1984) p. 132—134.

De même le brevet US n° 4.481.062 décrit une source d'ions à une chambre à confinement magnétique multipolaire avec une cathode chaude, chauffée par courant continu ou courant alternatif du secteur, et une anode, une source de courant continu appliquant une différence de potentiel continue entre cathode et anode.

En ce qui concerne le confinement magnétique multimiroir, on a également proposé des sources d'ions à deux ou trois chambres d'ionisation, par exemple dans la demande de brevet français n° 2.550.681 déposée le 12 août 1983 par le demandeur et mise à la disposition du public à partir du 15 février 1985, le confinement des ions et des électrons dans la troisième chambre d'ionisation (lorsqu'il y a trois chambres) étant obtenu par une configuration magnétique multimiroir réalisée par des couronnes ou des rangées de pôles magnétiques alternés disposées autour de cette chambre. Ce type de source convient très bien pour l'opération avec des gaz chimiquement réactifs ne donnant pas naissance à des dépôts isolants car dans cette éventualité l'excitation, par champ électrique continu du plasma de la troisième chambre présente le même inconvénient que celui décrit à propos des sources du type A. De plus il convient de remarquer que, même en écartant cette éventualité, la source à trois chambres ainsi obtenue est gouvernée par un grand nombre de paramètres et qu'en contrepartie de ses bonnes performances (uniformité, stabilité du plasma et rendement d'ionisation), elle est plus délicate à piloter et par suite à automatiser.

On signalera aussi la demande de brevet allemand n° 31 34 337 publiée initialement (D.O.S.) le 24 mars 1983 qui décrit un canon d'ions mettant en oeuvre une haute fréquence allant jusqu'à 2 × $10^6$ kHz entre électrodes dans la chambre d'ionisation. Aucun dispositif de confinement magnétique du type multipolaire n'est prévu dans cette demande de brevet.

Plus particulièrement dans cette demande de brevet allemand le dispositif comporte une structure plane du type diode sans aucun champ magnétique, les deux électrodes formant diode se faisant face.

La source d'ions selon DE—A—3.134.337 se caractérise par une structure plane du type diode, avec deux électrodes d'ionisation qui se font face, les deux électrodes étant planes et parallèles, et l'absence de champ magnétique.

Au contraire selon l'invention, on prévoit une structure spatiale du type triode, avec deux électrodes d'ionisation en contact avec le plasma, qui ne se font pas face, et une électrode de polarisation indépendante.

Il en résulte de nombreux avantages parmi lesquels on peut indiquer:

—du fait que la troisième électrode est polarisée indépendamment des électrodes d'ionisation, on peut choisir cette polarisation (positive, négative ou alternative) en fonction de l'application envisagée de la source d'ions;

—la présence d'un champ magnétique du type multipolaire ou multimiroir, créé par un système de pôles magnétiques alternés disposés tout autour ou en partie autour de la chambre d'ionisation, au contact de l'électrode d'ionisation extérieure, assure l'homogénéité du plasma sur une section, ce qui n'est pas possible dans le cas d'un champ haute fréquence uniforme, comme dans le cas du document DE—A—3.134,337; en effet la présence d'un tel champ multipolaire dans la chambre d'ionisation crée un profil de densité avec un large plateau (c'est-à-dire homogène sur une section), d'autant plus uniforme que la présence de ce champ magnétique multipolaire permet au plasma d'être créé à des pressions notablement plus basses (5 à 10 fois plus basses que dans le cas du DE—A—3.134.337);

—le plasma est uniforme sans que le champ haute fréquence le soit, alors que selon le DE—A—3.134.337 le champ haute fréquence doit être uniforme;

— la troisième électrode à polarisation indépendante permet de fixer l'énergie et le flux des particules chargées qui vont soit frapper cette électrode, lorsqu'elle est pleine et constitue une cible porteéchantillon, soit traverser cette électrode, dans le cas où elle est constituée par une grille d'émission d'ions, ce qui assure une maitrise accrue des paramètres du dispositif.

Enfin Guarnieri et Kaufman ont décrit dans IBM Technical Disclosure Bulletin, vol. 24, n° 11B, avril 1982, pages 5833—5835 (New-York) une excitation haute fréquence dans une chambre à deux électrodes, également sans confinement magnétique multipolaire.

La présente invention a pour but de perfectionner les sources d'ions du type antérieur, notamment les sources d'ions du type C ci-dessus, afin d'obtenir des sources présentant une très longue durée de vie — la durée de vie étant un paramètre fondamental pour une application industrielle — tout en assurant le meilleur compromis entre, d'une part, les critères caractérisant le flux d'ions disponible, à savoir en particulier l'uniformité et la stabilité sur de larges sections, l'absence de pollutions par des particules ou des rayonnements parasites, le rapport du flux d'ions au flux de neutres, et, d'autre part, les critères caractérisant la source d'ions, en particulier sa simplicité de mise en oeuvre et d'automatisation, et sa fiabilité, critères qui, selon le cahier des charges des applications actuelles, doivent être extrêmisés (maximalisés ou minimisés selon le cas).

Par rapport à la source selon la demande de brevet français de la demanderesse mentionée ci-dessus, la source d'ions selon l'invention réalise une amélioration notable quant à la simplicité de mise en oeuvre et d'automatisation aux dépens d'un sacrifice quant au rapport, flux d'ions/flux de neutres traduisant l'efficacité d'ionisation de la source par suite d'une augmentation, de la pression limite jusqu'à laquelle la décharge peut être maintenue dans la source avec une densité de charges significative.

Pour ce faire la nouvelle source d'ions est une source d'ions à une seule chambre d'ionisation dans la quelle le plasma est créé par l'excitation d'un gaz à l'aide d'un champ électrique de haute fréquence entre deux électrodes d'ionisation et elle met en oeuvre une troisième électrode de polarisation, à polarisation indépendante, et un confinement magnétique du type multipolaire, c'est-à-dire multimiroir, réalisé par des couronnes ou des bandes de pôles magnétiques alternées disposées autour de cette chambre.

Plus précisément l'invention a pour objet une source d'ions comportant une seule chambre d'ionisation et de formation de plasma, avec deux électrodes d'ionisation, des moyens pour injecter dans ladite chambre au moins un gaz à ioniser, au moins un orifice d'évacuation de gaz hors de ladite chambre et des moyens de pompage contrôlé pour aspirer du gaz hors de ladite chambre par ledit au moins un orifice, caractérisée en ce que:

les deux électrodes d'ionisation sont amagnétiques et en contact avec le plasma formé dans ladite chambre, l'une desdites deux électrodes d'ionisation, appelée électrode d'ionisation extérieure, constituant au moins une partie de la paroi de ladite chambre, l'autre de ces deux électrodes, appelée électrode d'ionisation intérieure, étant disposée dans ladite chambre; et en ce qu'elle comprend:

une électrode de polarisation disposée à l'extrémité d'extraction des ions de ladite chambre;

des moyens pour appliquer entre lesdites deux électrodes d'ionisation une haute tension alternative à haute fréquence suffisante pour ioniser ledit au moins un gaz injecté dans ladite chambre et pour créer un plasma à l'intérieur de ladite chambre;

des moyens pour appliquer une différence de potentiel entre ladite électrode de polarisation et une desdites électrodes d'ionisation, afin de polariser ladite électrode de polarisation de manière indépendante; et

un système d'aimants permanents avec pôles magnétiques alternés pour créer une configuration magnétique du type multipolaire ou multimiroir au voisinage immédiat de ladite électrode d'ionisation extérieure.

La source d'ions selon l'invention peut fonctionner selon deux modes, le premier, dit "source d'ions en plasma" conduisant à une irradiation des échantillons au sein même du plasma et le second dit "source d'ions en faisceau" conduisant à une irradiation des échantillons à l'extérieur de la chambre d'ionisation, dans une atmosphère gazeuse à pression contrôlable indépendamment.

Dans le premier cas, l'échantillon à irradier par les ions est disposée à l'intérieur de la chambre d'ionisation contre la troisième électrode qui est alors une cible pleine (à l'éventuel orifice d'évacuation des gaz près) et les ions sont accélérés depuis le plasma où ils sont créés par la tension négative appliquée sur la troisième électrode, ce qui assure l'indépendance entre l'intensité du flux d'ions et l'énergie des ions; par contre l'incidence des ions sur l'échantillon est pratiquement normale (perpendiculaire) et l'irradiation se fait à la pression nécessaire pour l'établissement du plasma et dans une atmosphère de particules neutres (molécules ou radicaux) résultant de la création de ce plasma dont la physicochimie est le plus souvent fort complexe.

Dans le second cas, ces deux derniers inconvénients peuvent être éliminés, les échantillons étant placés à l'extérieur de la chambre d'ionisation dont la troisième électrode est alors perforée d'un grand nombre d'ouvertures (trous circulaires ou fentes) — elle porte alors le plus souvent le nom de grille d'émission d'ions à travers lesquelles les ions du plasma peuvent être accélérées, puis formés en faisceau dirigé vers l'échantillon grâce à un système optique comportant zéro, une ou deux grilles supplémentaires (respectivement d'accélération et de décélération dans le cas de deux grilles), dont les ouvertures sont soit alignées, soit volontairement décalées par rapport à celle de la grille d'émission d'ions, et en aval de ces grilles supplémentaires on peut prévoir un dispositif d'injection d'électrons qui assure la compensation de la charge d'espace positive du faisceau d'ions formé tant en densité volumique (pour éviter l'éclatement du faisceau sous l'action des forces électriques dues à la charge d'espace) qu'en courant (si le besoin s'en fait sentir, par exemple en cas d'interaction avec un échantillon isolant, ne permettant pas l'écoulement des charges positives).

L'extérieur de la chambre d'ionisation est généralement placé à la pression atmosphérique et il y aura donc lieu de prévoir, entre les différentes électrodes, des éléments assurant à la fois l'isolement électrique et l'étanchéité empêchant le passage des gaz. Il est cependant possible de placer l'ensemble de la chambre d'ionisation dans une enceinte où règne un vide partiel.

Les deux électrodes d'ionisation sont connectées aux bornes du générateur haute fréquence en réalisant un couplage capacitif qui crée le plasma, contrairement à ce qui se passe dans les sources d'ions dans lesquelles la différence de potentiel haute fréquence est appliquée aux bornes d'une électrode en forme de bobine d'induction, le couplage étant alors de type selfique (certaines sources d'ions du type C ci-dessus).

L'électrode d'ionisation intérieure peut être soit de type multitube, les tubes ayant par exemple une section circulaire ou rectangulaire, éventuellement carrée avec dans certains cas injection de gaz à ioniser par les tubes, soit constituée par une surface de forme plane ou courbe (notamment cylindrique ou sphérique).

Dans le cas d'une électrode d'ionisation intérieure plane ou courbe, la densité de courant du flux d'ions est plus faible que pour une électrode d'ionisation intérieure multitube mais la tension d'autopolarisation de cette électrode plane ou courbe est plus élevée; donc une telle forme est très favorable au dépôt, sur l'électrode de polarisation, d'une couche mince de particules extraites de l'électrode d'ionisation intérieure sous l'impact des ions de forte énergie issus du plasma, selon la méthode connue sous le nom de "pulvérisation cathodique"; de plus le fait de donner à l'électrode d'ionisation intérieure une forme concave (cylindrique ou sphérique) en direction de l'électrode de polarisation permet de concentrer le flux de neutres sur une surface plus faible de l'électrode de polarisation et donc d'augmenter le taux de croissance de la couche sur cette surface restreinte.

A l'opposé, si l'on souhaite faire un dépôt à partir d'une réaction chimique en phase plasma ou bien la gravure d'un échantillon porté par l'électrode de polarisation, tout dépôt issu de la pulvérisation de l'électrode d'ionisation intérieure constitue une "pollution"; pour ces méthodes, une électrode d'ionisation intérieure multitube est donc nettement préférable. Pour beaucoup d'applications ce sera effectivement cette structure qui sera la mieux adaptée.

Etant donné qu'un plasma contient des électrons et des ions, mais aussi des neutres, des radicaux libres et des photons, qui peuvent être actifs soit au sens du dépôt, soit au sens de la gravure, il y a lieu de prévoir l'évacuation des gaz injectés et de ceux formés au sein du plasma soit en volume, soit par suite de l'intéraction avec l'échantillon (effet de charge). Il faut pouvoir régler indépendamment le débit et la pression des neutres présents dans la chambre. L'orifice de communication avec le système de pompage peut être ménagé soit dans l'anode, soit dans l'électrode de polarisation; une vanne de réglage est avantageusement prévue sur la canalisation de pompage.

En ce qui concerne l'optique de la source d'ions "en faisceau", on prévoit, selon l'énergie souhaitée pour les ions qui irradient l'échantillon:

a) une optique à une seule grille, constituée par une grille d'émission d'ions, à maille très fine. Cette grille d'émission d'ions comme le porte-échantillon sont au potentiel du sol et c'est l'ensemble des deux électrodes d'ionisation qui est porté à un potentiel positif par rapport au sol (50 à 150 V par exemple); les ions ont alors une énergie faible en arrivant sur l'échantillon, de l'ordre de 50 à 150 eV;

b) une optique à deux ou trois grilles, pour le cas où l'on souhaite avoir des énergies plus élevées (par exemple 150—1500 eV); dans ce cas également le faisceau et l'échantillon sont en général au potentiel du sol et l'ensemble de la chambre d'ionisation, de ses alimentations de puissance et des circuits de gaz et de refroidissement sont portés à une haute tension positive (par exemple 150—1500 V); ici encore, du fait de l'excitation haute fréquence, le générateur haute fréquence peut être laissé au potentiel du sol, le couplage avec la chambre se faisant par l'intermédiaire de condensateurs d'isolement, seule la chambre et ses périphériques mécaniques étant portés à un potentiel positif.

Il est possible, avec cette configuration de source d'ions en "faisceau", de
—faire varier indépendamment l'intensité et l'énergie du flux d'ions,
—faire varier indépendamment l'incidence des ions, alors que, dans le cas d'un fonctionnement en plasma, l'incidence est normale quelle que soit l'inclinaison de l'échantillon dans la chambre à plasma (c'est une particularité des plasmas),
—faire varier la pression des neutres dans la chambre de réaction; en particulier on peut l'abaisser fortement avec un système de pompage puissant; on peut aussi — après avoir abaissé cette pression associée aux neutres injectés dans la source — introduire une nouvelle espèce de gaz (éventuellement réactif) au niveau de l'échantillon.

Cette variante de source d'ions en faisceau, qui est un peu complexe à mettre en oeuvre par rapport à la source d'ions "en plasma", offre plus de possibilités; c'est une voie d'avenir pour les circuits intégrés complexes à très haut degré d'intégration.

Le confinement magnétique multimiroir est assuré à partir d'aimants permanents d'aussi bonne qualité que possible (par exemple d'aimants au cobalt-samarium), de formes soit cylindriques soit parallélépipédiques disposés au contact des parois de la chambre qui sont amagnétiques et d'épaisseur aussi faible que possible pour ne pas affaiblir le champ magnétique de ces aimants.

Il existe plusieurs possibilités pour disposer ces différents aimants afin de créer une configuration de champ magnétique multimiroir autour d'une chambre par exemple cylindrique:
—arrangement de pôles NORD et SUD alternés dans deux directions, donnant la configuration à miroirs multiples et ponctuels connue dans la technique sous le nom de configuration "point cusp" ou "checkerboard";
—arrangement de bandes de pôles d'un même signe, mais alternées et parallèles aux génératrices du cylindre, les lignes pouvant être soit discontinues (brisées) soit continues, cette dernière solution, donnant en général les meilleurs résultats; on obtient des miroirs multipôles linéaires de configuration dite "broken line cusp" ou "full line cusp".
—arrangement de couronnes de pôles d'un même signe, mais alternées et perpendiculaires aux génératrices du cylindre, configuration dite "ring cusp".

A ce sujet on peut se référer par exemple à un article de la Rev. Sci. Instrum., Vol. 44, n° 6, Juin 1973.

L'invention pourra, de toute façon, être bien comprise à l'aide du complément de description qui suit, ainsi que des dessins ci-annexés, lesquels complément et dessins sont, bien entendu, donnés surtout à titre d'indication.

Les figures 1 et 2 illustrent, en coupe, une source d'ions du type triode selon l'invention à une seule chambre d'ionisation, à excitation haute fréquence et à confinement magnétique multipolaire, respectivement conçue selon le mode source d'ions "en plasma" (figure 1) ou selon le mode source d'ions "en faisceau" (figure 2).

La figure 3 est une coupe par III—III de la figure 1 et de la figure 2.

La figure 4 illustre, en coupe simplifiée, une variante de la source d'ions selon la figure 1.

La figure 5 illustre, en coupe simplifiée, une variante de la source d'ions selon la figure 2.

La figure 6 illustre schématiquement une variante des sources précédentes, dans laquelle on applique une tension alternative basse fréquence entre la troisième électrode et l'ensemble des deux électrodes de polarisation.

Les figures 7 et 8 illustrent, schématiquement et en coupe, des sources d'ions avec d'autres modes de réalisation de l'électrode d'ionisation intérieure (à savoir une électrode plane dans le cas de la figure 7 et une électrode cylindrique ou sphérique dans le cas de la figure 8) que celui des sources d'ions des figures 1 à 3.

La figure 9 illustre deux modes de réalisation d'une structure multipolaire réalisant des miroirs multiples linéaires.

La figure 10 est un graphique montrant l'amélioration, concernant le profil de la densité de courant du flux d'ions qui irradie l'électrode de polarisation, réalisée avec une source d'ions selon l'invention, comparée à une source d'ions analogue, mais ne comportant pas de confinement magnétique multipolaire.

La figure 11 illustre la variation de la densité de courant (en mA/cm²) du flux d'ions (en mA) irradiant la partie centrale de l'électrode de polarisation en fonction de la pression de décharge pour deux types de sources d'ions, à savoir une source selon l'invention à confinement multipolaire par des bandes de pôles alternés (en traits pleins) et une source analogue mais sans confinement des charges (traits mixtes).

La figure 12, enfin, représente la variation de la densité de courant du flux d'ions (en mA/cm²), dans la partie centrale de l'électrode de polarisation, en fonction de la pression de $CF_4$ dans la décharge pour une source selon l'invention ayant respectivement soit une électrode d'ionisation intérieure constituée par plusieurs tubes, soit une électrode d'ionisation intérieure plane.

Selon l'invention, se proposant par exemple de réaliser une source d'ions du type triode à une seule chambre d'ionisation, à excitation haute fréquence et à confinement magnétique du type multipolaire, on s'y prend comme suit ou d'une manière analogue.

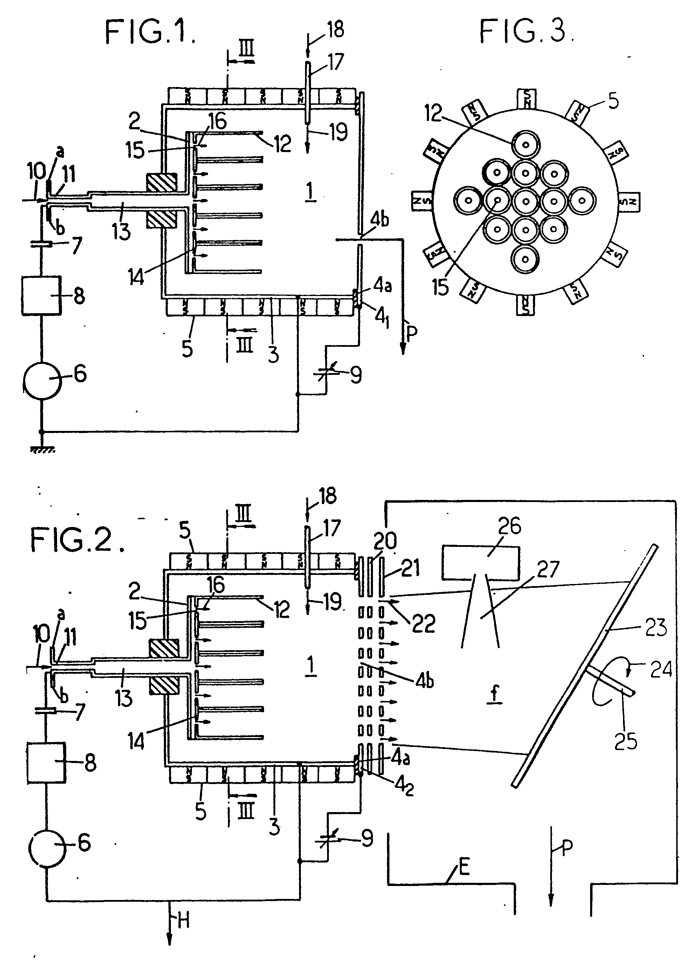

On se référera tout d'abord aux figures 1 à 3 qui illustrent deux modes de réalisation à électrode d'ionisation intérieure multitube.

Les figures 1 et 2 illustrent, en coupe axiale, deux sources d'ions du type triode selon l'invention comportant une seule chambre d'ionisation, à excitation haute fréquence et à configuration magnétique multipolaire, la figure 3 qui est une coupe par III—III des figures 1 et 2 montrant justement la structure réalisant le confinement magnétique multipolaire.

Le mode de réalisation de la figure 1 est spécialement conçu pour fonctionner selon le mode opératoire d'une source d'ions en plasma, tandis que la figure 2 est spécialement conçue pour fonctionner selon le mode opératoire d'une source d'ions en faisceau, comme indiqué précédemment.

On va commencer par décrire la partie qui est sensiblement commune aux structures des figures 1 et 2.

La source d'ions selon ces deux figures comprend tout d'abord une chambre unique d'ionisation 1 qui est, d'une part, évacuée et, d'autre part, alimentée en gaz à transformer en plasma, comme indiqué ci-après.

Au voisinage d'une des extrémités de la chambre 1 est disposée une électrode d'ionisation intérieure 2 qui, sur les modes de réalisation des figures 1 et 2, est constituée par une électrode d'ionisation intérieure multitube; cette électrode d'ionisation intérieure est avantageusement refroidie par circulation d'un fluide arrivant en $a$ et sortant en $b$.

L'électrode d'ionisation intérieure 2 coopère avec une électrode d'ionisation extérieure 3 qui constitue une grande partie de la paroi de la chambre 1.

En plus des électrodes d'ionisation 2 et 3 précitées, on prévoit une troisième électrode constituée par une électrode de polarisation pleine $4_1$ (à part éventuellement un ou plusieurs orifices 4b d'évacuation de la chambre 1), comme c'est le cas dans la source de la figure 1, ou par une grille $4_2$ d'émission d'ions apte à laisser passer les ions du plasma depuis l'intérieur de la chambre d'ionisation, comme dans le mode de réalisation de la figure 2, la troisième électrode, de polarisation, $4_1$ ou $4_2$ étant disposée à l'autre extrémité de la chambre d'ionisation 1 par rapport à l'extrémité voisine de l'électrode d'ionisation intérieure 2.

Une bague 4a d'étanchéité et d'isolement électrique est disposée le long de la périphérie de l'électrode $4_1$, $4_2$ du côté de la chambre d'ionisation 1 ce qui permet de mettre sous vide l'ensemble de la chambre 1 si on le désire.

Le confinement magnétique est réalisé au moyen d'un système de pôles magnétiques NORD (N) et SUD (S) référencés 5, qui sont disposés d'une manière alternée, notamment comme on le voit sur la figure 3.

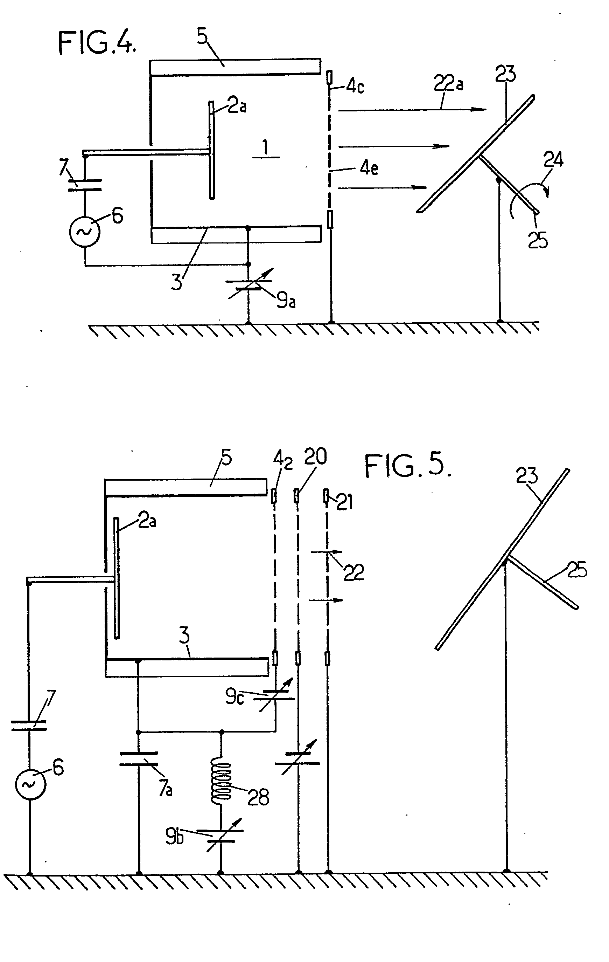

D'autres modes de réalisation de l'électrode d'ionisation intérieure, d'une part, et du système de confinement magnétique du type multipolaire, d'autre part, sont exposés ci-après, notamment avec référence aux figures 4, 5, 7, 8 et 9.

Les deux électrodes d'ionisation (intérieure 2 et extérieure 3) sont soumises à une haute tension alternative à haute fréquence qui produit, par couplage capacitif à l'intérieur de la chambre 1, un plasma à partir du gaz introduit dans cette chambre.

La haute fréquence est produite par un générateur haute fréquence 6 dont la fréquence est au moins égale à la valeur de la fréquence limite inférieure à partir de laquelle le plasma de la chambre est allumé en permanence dans un état d'équilibre stationnaire indépendant du temps, cette haute fréquence du générateur 6 étant par exemple supérieure à 20—50 kHz.

Avantageusement, on prévoit, en série avec le générateur haute fréquence 6, un condensateur de blocage 7 qui supprime toute composante continue dans l'alimentation de l'électrode d'ionisation intérieure 2, donc tout transport de courant continu entre cette électrode d'ionisation intérieure 2 et l'électrode d'ionisation extérieure 3, et qui assure ainsi à ladite électrode d'ionisation intérieure 2 une polarisation continue moyenne automatique par rapport à l'électrode 3, créant ainsi une dissymétrie électrique entre ces deux électrodes, en plus de la dissymétrie géométrique. On peut également prévoir dans l'alimentation de l'électrode d'ionisation intérieure 2 un circuit d'adaptation d'impédance 8 de façon à améliorer le transfert de puissance depuis le générateur 6 vers la décharge électrique dans la chambre 1, en réduisant la puissance réfléchie par l'impédance ainsi adaptée.

Pour réaliser une polarisation entre l'ensemble des électrodes d'ionisation 2 et 3, d'une part, et la troisième électrode de polarisation $4_1$ ou $4_2$, d'autre part, on prévoit, dans les sources d'ions des figures 1 et 2, une source de tension continue, mais variable, 9, de manière à appliquer à l'électrode de polarisation pleine $4_1$ ou à la grille d'émission d'ions $4_2$ un potentiel choisi a priori par rapport à l'électrode d'ionisation extérieure 3, ce potentiel étant généralement de valeur négative pour réaliser l'accélération des ions.

L'alimentation en gaz à transformer en plasma, c'est-à-dire en un mélange comportant essentiellement des électrons négatifs et des ions positifs, dans la chambre 1 par la décharge produite entre l'électrode d'ionisation intérieure 2 et l'électrode d'ionisation extérieure 3 est réalisée:

—à travers l'électrode d'ionisation intérieure 2, qui est dans ce cas une électrode d'ionisation intérieure creuse, le gaz à ioniser étant amené, comme illustré par la flèche 10, à l'entrée 11 de l'électrode d'ionisation intérieure; l'électrode d'ionisation intérieure proprement dite est en effet alors constituée par plusieurs tubes 12, disposés par exemple comme illustré sur la figure 3, et la répartition du gaz arrivant en 10 est réalisée grâce à un épanouissement 13 et un distributeur 14; le gaz à ioniser débouche finalement dans la chambre d'ionisation 1 par les orifices 15 ménagés au fond des tubes 12 comme illustré par les flèches 16; et/ou

—grâce à une amenée de gaz par une canalisation 17 (qui traverse la paroi de la chambre 1) dans laquelle le gaz à ioniser pénètre suivant la flèche 18 et sort suivant la flèche 19 pour atteindre la chambre 1.

On va décrire maintenant la partie aval de la chambre d'ionisation 1, qui est différente dans les figures 1 et 2.

Dans le cas de la figure 1, l'électrode de polarisation $4_1$ est une cible pleine, à part un ou plusieurs orifices d'évacuation 4b qui communiquent avec un dispositif de pompage, de préférence réglable, représenté symboliquement par la flèche P.

L'électrode de polarisation $4_1$ peut porter des plaquettes constituant les échantillons frappés par les ions et également les neutres (issus par exemple de la pulvérisation de l'électrode d'ionisation intérieure 2 dans le cas d'un dépôt sur cette électrode d'ionisation intérieure) du plasma formé dans la chambre 1 par la décharge provoquée entre l'électrode d'ionisation intérieure 2 et l'électrode d'ionisation extérieure 3 sous l'effet du générateur haute fréquence 6. Comme indiqué précédemment, ce plasma est produit à partir du ou des gaz arrivant en 10 et/ou en 18.

Dans le cas de la source d'ions de la figure 2, on prévoit, derrière la grille d'émission d'ions $4_2$ avec les ouvertures 4b, deux électrodes supplémentaires formant un ensemble d'extraction, à savoir une électrode accélératrice 20 et une électrode décélératrice 21 portées, par rapport à l'électrode $4_2$, à des différences de potentiel négatives, l'électrode 20 étant plus négative que l'électrode 21 (on n'a pas illustré sur la figure 2 les sources de tension alimentant les électrodes 20 et 21 du fait qu'elles sont classiques; par contre ces sources de tension son illustrées dans le mode de réalisation de la figure 5).

Les électrodes supplémentaires 20 et 21 sont perforées le faisceau d'ions sortant de la source à, travers les ouvertures de l'électrode décélératrice 21, comme illustré par les flèches 22 et il arrive (en f) dans une enceinte E évacuée par un système pompage matérialisé par la flèche P. Cette chambre E constitue la chambre de réaction dans laquelle est placée l'echantillon.

Dans le cas de la figure 2 l'échantillon est porté par un dispositif porte-échantillon ou porte-plaquette 23 pouvant tourner, comme indiqué par la flèche 24, autour d'un axe 25; il est situé dans la chambre à pompage indépendant E dans laquelle la pression Pe peut être amenée à être inférieure à Ps qui est la pression dans la chambre d'ionisation 1.

Enfin on peut prévoir dans le mode de réalisation de la figure 2 un dispositif neutraliseur à plasma 26 envoyant un jet de plasma 27 dans le faisceau d'ions f entre l'électrode décélératrice 21 et l'échantillon sur le porte-échantillon 23 afin de compenser le fais ceau d'ions positifs en charges volumiques et éventuellement en courant.

On voit donc que la source d'ions selon l'invention constituée par la partie commune des figures 1 et 2 permet deux fonctionnements différents, à savoir:

— d'une part (figure 1), le fonctionnement de la source d'ions en plasma (à la pression des neutres égale à la pression décharge);

— d'autre part (figure 2), le fonctionnement de la source d'ions avec formation d'un faisceau d'ions f se propageant dans une atmosphère raréfiée en neutres par rapport au cas de la figure 1.

Avec les deux types, "en plasma", et "en faisceau", on peut réaliser par exemple une gravure, notamment de circuit intégré, gravure en plasma dans le cas de la figure 1 (fonctionnement du type RIE: Reactive Ion Etching) et gravure réactive en faisceau dans le cas de la figure 2 (fonctionnement du type RIBE: Reactive Ion Beam Etching).

Dans le premier cas, la gravure a lieu au sein même de la chambre d'ionisation 1 au moyen du plasma formé dans cette chambre et elle est très uniforme grâce à l'excellente homogénéité du plasma obtenu dans la source d'ions selon l'invention; elle se fait par impact sous incidence normale (perpendiculairement à l'échantillon) et peut donc être très anisotrope, ce qui, en règle générale, est le but recherché.

Dans le second cas l'optique d'extraction d'ions, constituée par les électrodes 20 et 21 permet de sortir un faisceau d'ions f de la chambre d'ionisation, de le propager dans une atmosphère raréfiée (Pe beaucoup plus petit que Ps), ces ions étant projetés sur l'échantillon disposé sur le porte-plaquette 23, le flux et l'énergie des ions étant suffisants pour assurer une excellente gravure, avec l'avantage ici de pouvoir modifier à souhait l'angle d'incidence des ions sur l'échantillon.

On va décrire maintenant avec référence aux figures 4 à 9 des variantes des sources d'ions des figures 1 à 3.

La figure 4 illustre une variante du mode de réalisation de la figure 1, dans laquelle on a remplacé l'électrode multibube 2 de la figure 1 par une électrode plane 2a.

En outre sur la figure 4 on a explicité le porte-échantillon 23 apte à tourner en rotation autour de l'axe 25 dans le sens de la flèche 24.

La figure 4 est une figure schématique sur laquelle on retrouve les ensembles multipôles 5, le géné-rateur 6 qui engendre la haute fréquence appliquée, à entre les deux electrodes d'ionisation, savoir l'électrode d'ionisation intérieure plane 2a et l'électrode d'ionisation extérieure 3, réalisant le couplage capacitif, dans la chambre d'ionisation 1, et le condensateur 7 par contre on n'a pas illustré le circuit facultatif 8 d'adaptation d'impédance de la figure 1.

Une autre différence avec le mode de réalisation de la figure 1 est le fait que la troisième électrode de polarisation est une grille 4c d'émission d'ions laissant passer par ses mailles très fines 4e le faisceau d'ions 22a.

Sur la figure 4 on n'a représenté ni l'enceinte évacuée, ni la source de pompage, qui peuvent être analogues à celles de la source d'ions illustrée sur la figure 2.

On notera que la grille 4c d'émission d'ions comme le porte échantillon 23 sont mis au potentiel du sol, l'ensemble des deux électrodes d'ionisation 3 et 2a étant porté à un potentiel positif par rapport au sol par la source 9a qui peut appliquer un potentiel variable compris, par exemple, entre 50 et 15 volts par rapport au sol; dans ce cas les ions ont une énergie faible en arrivant sur l'échantillon, énergie de l'ordre de 50 à 150 eV.

Alors que la figure 4 illustre, en regard d'une electrode d'ionisation interieure plane 2a une optique, à une seule grille, à savoir la grille 4c d'émission d'ions la figure 5 qui est une variante de la figure 2, illustre une optique à plusieurs grilles, à savoir trois grilles toujours avec une électrode d'ionisation intérieure plane 2a.

Sur la figure 5 on retrouve la grille $4_2$, d'émission d'ions, la grille ou électrode accélératrice 20 et la grille ou électrode décélératrice 21, le faisceau d'ions sortant en tant que faisceau 22.

Comme la figure 4, la figure 5 est une figure simplifiée sur laquelle le système de pôles magnétiques 5 n'a pas été explicité, ce système entourant l'anode 3.

De même on n'a pas illustré l'enceinte évacuée E de la figure 2 dans laquelle se trouve le porte-échantillon rotatif 23 porté par un axe 25.

Sur la figure 5 on retrouve le condensateur 7 et le générateur haute fréquence 6, ce générateur étant au potentiel du sol, alors que dans le mode de réalisation de la figure 2 une haute tension H est appliquée entre le sol et le générateur 6.

C'est grâce aux condensateurs d'isolement 7 et 7a que la connexion du générateur 6 au sol est possible, dans le cas de la figure 5, le couplage avec la chambre se faisant à travers ces condensateurs d'isolement 7, 7a.

A la place de la seule source de potentiel variable 9 de la figure 2, on a prévu dans le mode de réalisation de la figure 5 deux sources 9b et 9c entre lesquelles est disposée une bobine de self 28 destinée à bloquer la haute fréquence.

Dans les sources d'ions des figures 1 à 3, d'une part, et les variantes des figures 4 et 5, d'autre part, on a mis en oeuvre des polarisations en courant continu de la troisième électrode de polarisation (grille pleine porte-échantillon ou grille d'émission d'ions).

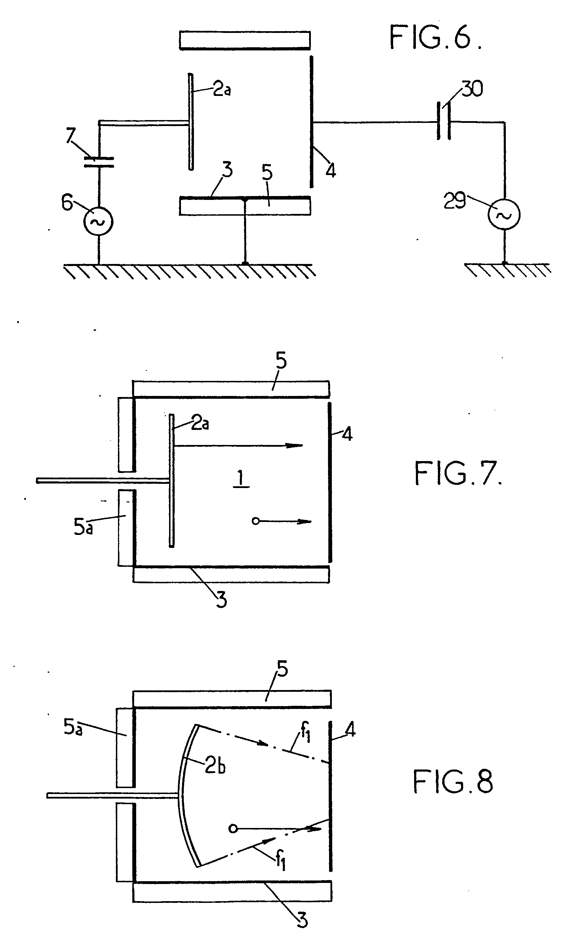

Alors que la polarisation haute fréquence créée par le générateur 6 sert à créer le plasma dans la chambre d'ionisation 1, la polarisation de la troisième électrode sert à attirer les ions formés dans ce plasma et à leur communiquer l'énergie souhaitée pour l'intéraction avec l'échantillon, porté par le porte-échantillon 23 ou par la troisième électrode, leur flux ($I^+_{AK}$) sur l'ensemble de l'électrode de polarisation pleine ou grille d'émission d'ions n'étant pratiquement pas modifié par la valeur de la tension appliquée sur cette troisième électrode; c'est l'avantage de la structure "triode" qui permet de fixer indépendamment à la fois le flux et l'énergie des ions qui agissent sur un échantillon porté par cette troisième électrode, dans le cas de l'invention. Pour cette configuration on peut prévoir une polarisation par tension continue, mais aussi, en variante, une polarisation par une tension alternative auxiliaire, dont la fréquence peut être faible (quelques kHz) le plasma étant créé par ailleurs pour les cas où l'échantillon est un diélectrique ou bien si la couche élaborée est elle-même de nature diélectrique. En effet une polarisation continue est alors inopérante; donc la variante à tension de polarisation négative de la troisième électrode par rapport aux électrodes d'ionisation est d'usage plus général, à réaliser selon le montage illustré schématiquement sur la figure 6.

Sur cette figure 6, à la place d'une polarisation continue de la troisième électrode, on prévoit une polarisation par une tension alternative auxiliaire de fréquence égale à quelques kHz). Ici encore on met en oeuvre, par exemple, une électrode d'ionisation intérieure plane 2a, une électrode d'ionisation extérieure 3, une troisième électrode désignée 4 qui peut être du type grille d'émission d'ions ou cible pleine porte-échantillon, un système de pôles 5, un générateur haute fréquence 6 et un condensateur 7. Le générateur alternatif basse fréquence, à une fréquence de quelques kHz (par exemple 1 à 10 kHz), est illustré en 29. Un condensateur 30 est placé en série avec le générateur 29 entre le sol et l'électrode 4.

Le montage de la figure 6 est plus général en ce qui concerne l'application, étant donné qu'il convient également pour les échantillons en diélectrique ou les, couches élaborées de nature diélectrique.

On notera que la mise en oeuvre d'un générateur alternatif tel que 29, avec un condensateur de blocage 30, est également applicable à titre de variante de la figure 2, c'est-à-dire lorsqu'on prévoit une électrode accélératrice 20 et une électrode décélératrice 21, l'énergie étant communiquée aux ions par ces dernières électrodes; l'ensemble générateur 29-condensateur 30 est dans ce cas connecté à la grille $4_2$ d'émission d'ions à la place du générateur continu 9. Dans d'autres variantes de la figure 2, l'électrode $4_2$ pourrait être soit connectée à l'électrode d'ionisation extérieure 3, soit laissée flottante, c'est-à-dire connectée à l'électrode d-ionisation extérieure par une résistance de forte valeur. Ces deux dernières variantes peuvent également s'appliquer à une source d'ions du type illustré sur la figure 1.

La figure 7 illustre une autre variante à électrode d'ionisation intérieure plane 2a dans laquelle, en plus du système d'aimants 5 on prévoit également un second système d'aimants 5a disposés contre l'extrémité de la chambre d'ionisation 1 la plus voisine de l'électrode d'ionisation intérieure 2a, donc du côté de l'extrémité opposée à l'extrémité fermée par la troisième électrode 4 (du type $4_1$ ou $4_2$).

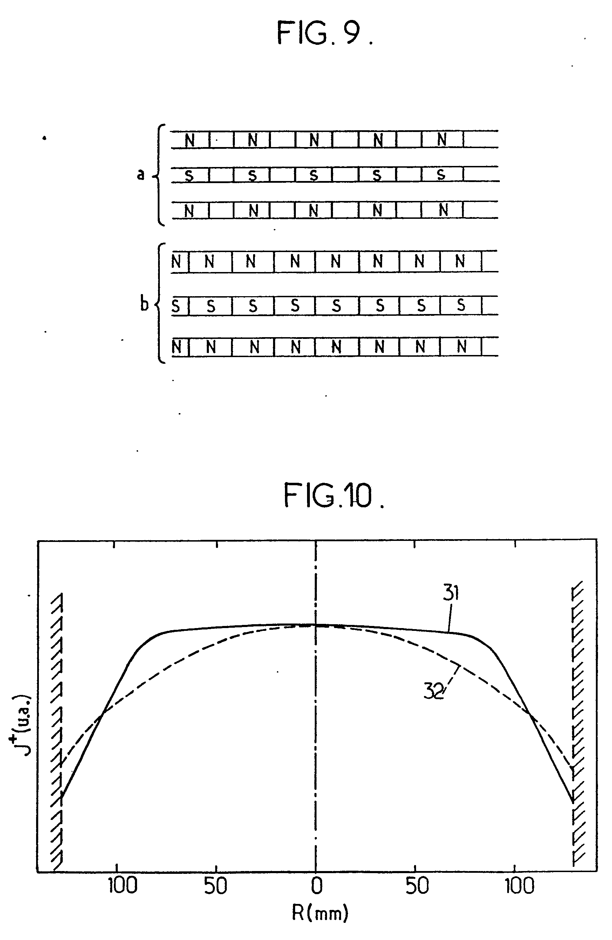

On exposera ci-après, avec référence à la figure 9, les différents systèmes d'aimants utilisables.

Jusqu'à présent on a mis en oeuvre deux types d'électrodes d'ionisation intérieure, à savoir des électrodes d'ionisation intérieure multitubes (figures 1 à 3) ou planes (figures 4 à 7).

On peut également mettre en oeuvre une électrode d'ionisation intérieure courbe, comme illustré sur la figure 8, sur laquelle l'électrode d'ionisation intérieure est référencée 2b. Sur la figure 8 on trouve les autres éléments de la figure 7.

L'avantage d'une électrode courbe du type sphérique ou cylindrique est qu'elle focalise plus ou moins les neutres, pulvérisés depuis cette électrode d'ionisation intérieure, en direction de la troisième électrode 4, comme illustré par les flèches $f_1$ limitant le faisceau d'ions produit par l'électrode d'ionisation intérieure 2b dont la concavité est dirigée vers la troisième électrode 4.

On notera qu'une électrode d'ionisation intérieure multitube, avec ou sans injection de gaz (sur les figures 1 et 2 on a illustré de telles électrodes d'ionisation intérieure à arrivée de gaz en 10 et sortie en 16) présente, par rapport à une électrode d'ionisation intérieure plane ou concave, les avantages suivants:

—le flux d'ions est plus intense sur l'électrode de polarisation;

—la tension d'autopolarisation de l'électrode d'ionisation intérieure est plus faible, donc il y a moins de pulvérisation et donc mcins de pollution.

C'est donc un mode de réalisation qui convient aux applications d'une source d'ions selon l'invention à la gravure, au dépôt par chimie au sein du volume de plasma, à l'oxydation et à la nitruration.

Par contre si on veut faire des dépôts, sur l'électrode de polarisation, de neutres pulvérisés depuis l'électrode d'ionisation intérieure, avec éventuellement dépôt de neutres formés en volume et le tout étant assisté par un bombardement ionique sur l'échantillon, la réalisation à électrode d'ionisation intérieure plane ou concave convient mieux.

La figure 9 illustre deux modes de réalisation a et b de miroirs multiples linéaires réalisés par des bandes ou rangées de pôles NORD (N) et SUD (S), les bandes de pôles pouvant être soit brisées (mode de réalisation a de la figure 9) soit continues (mode de réalisation b de la figure 9).

A la place des bandes parallèles aux génératrices de la chambre d'ionisation 1 (montage du type "line cusp"), on peut prévoir des couronnes perpendiculaires aux génératrices (montage du type "ring cusp"), les couronnes étant également soit du type brisées, soit du type continues.

Enfin on peut prévoir également des miroirs multiples ponctuels pour réaliser le confinement magnétique, ces miroirs étant du type "point cusp" ou du type "checkerboard", comme illustré respectivement sur les figures 1 et 6 de la Rev. Sci. Instrum., Vol. 44, n° 6, Juin 1973.

On voit donc que l'on peut finalement mettre en oeuvre dans le cadre de l'invention:

—des électrodes d'ionisation intérieure de différents types, notamment des électrodes d'ionisation intérieure du type illustré sur les figures 1 à 3, sur les figures 4 à 7, et enfin sur la figure 8;

—des troisièmes électrodes de type cible pleine porte-échantillon ou grille d'émission d'ions, avec éventuellement une ou plusieurs électrodes supplémentaires derrière la grille d'émission d'ions, telles que les électrodes 20 et 21 des figures 2 et 5;

—des polarisations continues ou alternatives de la troisième électrode;

—différents types de systèmes magnétiques pour réaliser un confinement magnétique multipolaire.

La figure 10 illustre l'avantage du confinement magnétique multipolaire qui est une des caractéristiques de l'invention. Sur cette figure 10 on a porté en abscisses, à partir de l'axe central 0, le rayon R en mm à partir de cet axe et en ordonnées la densité de courant j+ en unités arbitraires du flux d'ions irradiant l'électrode de polarisation, du type cible pleine, d'une source d'ions selon l'invention dans laquelle le générateur haute fréquence fonctionne à une fréquence de 13,56 MHz et d'une source non conforme à l'invention.

La courbe 31 en traits pleins correspond au cas d'un confinement magnétique multipolaire selon l'invention, tandis que la courbe 32 en traits interrompus illustre la variation du profil de la densité de courant pour la même source d'ions mais dans laquelle on a supprimé le confinement magnétique.

On notera aisément que le profil de la courbe 31 est amélioré par rapport au profil de la courbe 32 du fait qu'on obtient une densité de courant relativement constante sur un diamètre relativement important par la mise en oeuvre du confinement magnétique multipolaire. On notera que les deux courbes 31 et 32 ont été normalisées pour une même valeur maximale de densité de courant j+ du flux d'ions irradiant l'électrode de polarisation.

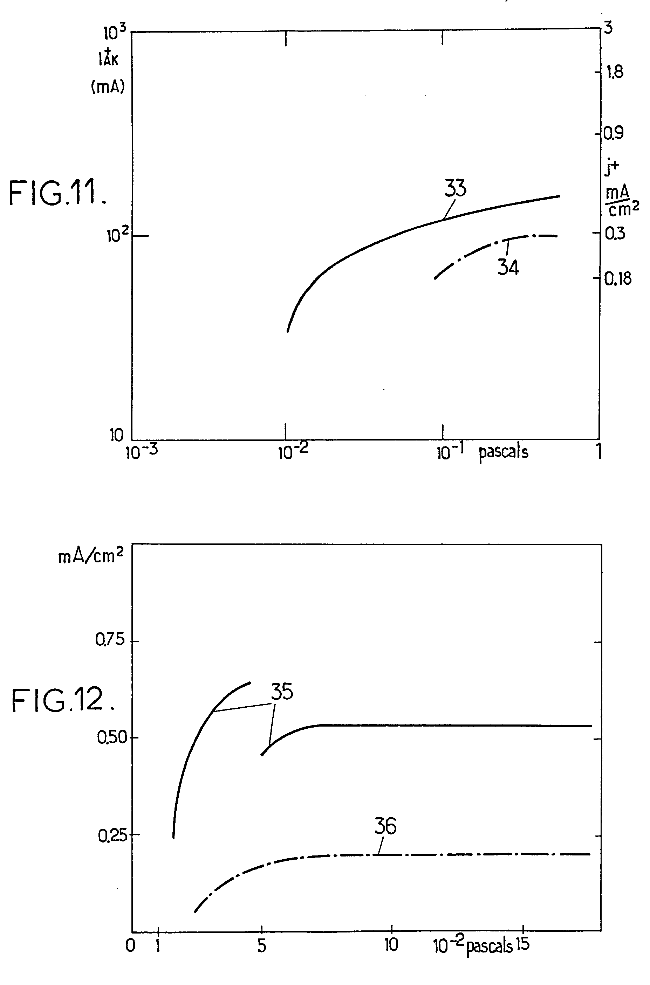

Sur la figure 11 on a illustré par la courbe 33 en traits pleins les caractéristiques d'une source d'ions selon l'invention et par une courbe 34 en traits mixtes celle d'une source d'ions analogues, mais dans laquelle il n'y a pas de confinement autour de la chambre d'ionisation, les lignes de pôles magnétiques alternés étant supprimées.

La figure 11, sur laquelle on a porté les pressions de décharge en abscisses et les densités de courant j+ (en mA/cm²) du flux d'ions $I^+_{AK}$ (en mA) irradiant l'électrode de polarisation, du type cible pleine, en ordonnées, montre que les densités de courant d'ions d'une source selon l'invention, bien qu'inférieures aux valeurs obtenues pour une excitation continue dans une tétrode ou une pentode (selon la demande de brevet français n° 2.550.681 précitée du demandeur), sont compatibles par exemple avec les critères requis pour la gravure ionique réactive aussi bien en plasma du type RIE qu'en faisceau du type RIBE; en effet dans les deux cas elle exige des densités de courant comprises entre 0,5 et 1 mA/cm², valeur qui peut être atteinte et même dépassée par la source d'ions selon l'invention pour des pressions de décharge comprises entre $10^{-2}$ pascal et $10^{-1}$ pascal et des puissances adéquates haute fréquence entre 500 et 1000 watts.

La possibilité de travailler à basse pression est intéressante pour la gravure RIE en plasma, car la pression des neutres affecte la qualité de la gravure aux dimensions submicroniques (anisotropie). Quant à l'opération en RIBE, elle impose une basse pression dans la chambre si on veut obtenir dans l'enceinte de réaction une pression suffisamment faible (quelques 10-3 pascal) sans mettre en oeuvre des pompes de très grosses capacités, encombrantes et onéreuses; la source d'ions selon l'invention répond parfaitement à ces deux critères, et mieux que les sources haute fréquence ou ultra haute fréquence antérieures.

La figure 12 illustre la variation de la densité de courant du flux d'ions (en mA/cm²), portée en ordonnées, en fonction de la pression de $CF_4$ (tétrafluorure de carbone) introduite dans la chambre d'ionisation dans la décharge, portée en abscisses, pour une source selon l'invention, l'une avec une électrode d'ionisation intérieure à plusieurs tubes (courbe 35 en traits pleins) et l'autre analogue mais comportant une électrode d'ionisation intérieure plane (courbe 36 en traits mixtes). On aperçoit facilement l'amélioration obtenue en ce qui concerne les flux. Dans les deux cas la puissance haute fréquence incidente est de 300 watts. Il n'existe pas de problème de durée de vie pour la source qui est insensible aux éventuels dépôts isolants sur les électrodes.

Finalement l'invention permet de réaliser une source d'ions apte à être utilisée tant en plasma qu'en faisceau et donnant pleine satisfaction en ce qui concerne la durée de vie qui est très grande, l'homogénéité du plasma qui est très bonne, la fragmentation des gaz injectés qui est moyenne, le rendement d'ionisation qui est moyen et la pression limite qui est de l'ordre de $10^{-2}$ pascal, et ceci au moyen d'une structure relativement simple, d'une alimentation aisée des électrodes et d'une automatisation simplifiée par le faible nombre de paramètres indépendants.

La source d'ions selon l'invention convient particulièrement pour réaliser la gravure, notamment des circuits intégrés, en utilisant du tétrafluorure de carbone et éventuellement d'autres gaz réactifs de type fluorocarbonés ou chlorocarbonés, éventuellement mélangés avec de l'oxygène.

Une telle source d'ions trouve en fait application pour les techniques suivantes utilisant des flux d'ions chimiquement réactifs (formés à partir de composés oxygénés, azotés, fluorés ou chlorés par exemple): technologie des circuits intégrés à haute intégration pour les processus tels que oxydation des semi-conducteurs, gravure des circuits intégrés par un faisceau d'ions réactifs, nitruration des semi-conducteurs, dépôt de couches minces par épitaxie, décapage des masques en résine et traitement de matériaux divers (outils en particulier).

## Revendications

1. Source d'ions en faisceau comportant une seule chambre d'ionisation et de formation de plasma, avec deux électrodes d'ionisation (3 et 2; 2a; 2b), des moyens (11, 13, 14, 15) pour injecter dans ladite chambre au moins un gaz à ioniser, au moins un orifice d'évacuation de gaz hors de ladite chambre, des moyens de pompage (P) contrôlé pour aspirer du gaz hors de ladite chambre par ledit au moins un orifice et des moyens (6) pour appliquer entre lesdites deux électrodes d'ionisation une haute tension alternative à haute fréquence suffisante pour ioniser ledit au moins un gaz injecté dans ladite chambre et pour créer un plasma à l'intérieur de ladite chambre, caractérisée en ce que:

les deux électrodes d'ionisation (3 et 2; 2a; 2b) sont amagnétiques et en contact avec le plasma formé dans ladite chambre (1), l'une desdites deux électrodes d'ionisation, appelée électrode d'ionisation extérieure (3), constituant au moins une partie de la paroi de ladite chambre, l'autre de ces deux électrodes, appelée électrode d'ionisation intérieure (2; 2a; 2b) étant disposée dans ladite chambre; et en ce qu'elle comprend:

une électrode de polarisation (4; $4_1$; $4_2$) disposée à l'extrémité d'extraction des ions de ladite chambre;

des moyens (9; 9a; 9b; 29) pour appliquer une différence de potentiel entre ladite électrode de polarisation et une desdites électrodes d'ionisation, afin de polariser ladite électrode de polarisation de manière indépendante; et

un système d'aimants permanents avec pôles magnétiques alternés (5; 5a) pour créer une configuration magnétique du type multipolaire ou multimiroir au voisinage immédiat de ladite électrode d'ionisation extérieure.

2. Source d'ions selon la revendication 1, caractérisée en ce que la haute fréquence de ladite haute tension alternative est supèrieure à 20 kHz.

3. Source d'ions selon la revenication 1 ou 2, caractérisée en ce qu'elle comporte un condensateur (7) disposé en série avec lesdits moyens pour appliquer une haute tension alternative à haute fréquence, entre lesdites électrodes d'ionisation extérieure et intérieure.

4. Source d'ions selon la revendication 3, caractérisée en ce qu'elle comporte en outre, dans l'alimentation de l'électrode d'ionisation intérieure (2), un circuit adaptateur d'impédance (8).

5. Source d'ions selon l'une quelconque des revendications précédentes, caractérisée en ce que ladite électrode d'ionisation intérieure (2) est constituée par l'association de plusieurs tubes (12).

6. Source d'ions selon la revendication 5, caractérisée en ce que les moyens (11, 13, 14, 15) pour injecter le gaz à ioniser dans ladite chambre injectent le gaz dans ces tubes (12).

7. Source d'ions selon l'une quelconque des revendications 1 à 4, caractérisée en ce que ladite électrode d'ionisation intérieure (2a) est plane.

8. Source d'ions selon l'une quelconque des revendications 1 à 4, caractérisée en ce que ladite électrode d'ionisation extérieure (2b) est concave, sa concavité étant dirigée vers ladite électrode de polarisation (4; $4_1$; $4_2$).

9. Source d'ions selon l'une quelconque des revendications précédentes, pour constituer une source du type "source d'ions en plasma", modifiée en ce que ladite électrode de polarisation ($4_1$) est une cible pleine porte-échantillon, à l'exception éventuellement de ous (4b) d'évacuation des gaz, et en ce que ladite cible est disposée pour fermer ladite extrémité d'extraction d'ions de ladite chambre d'ionisation (1), l'échantillon à bombarder par les ions étant appliqué contre ladite cible à l'intérieur de ladite chambre d'ionisation.

10. Source d'ions selon l'une quelconque des revendications 1 à 8, pour constituer une "source d'ions en faisceau", caractérisée en ce que ladite électrode de polarisation ($4_2$) est une grille d'émission d'ions apte à laisser passer les ions du plasma depuis l'intérieur de ladite chambre d'ionisation, l'échantillon à bombarder par les ions étant placé dans une chambre de réaction (E) indépendante de la chambre d'ionisation (1).

11. Source d'ions selon la revendication 10, caractérisée en ce qu'elle comporte en outre des moyens pour accélérer les ions traversant ladite grille ($4_2$) d'émission d'ions pour former un faisceau dirigé vers ledit échantillon.

12. Source d'ions selon la revendication 11, caractérisée en ce que lesdits moyens pour accélérer les ions sont constitués par une grille accélératrice (20) et une grille décélératrice (21), les ions s'échappant finalement à travers ladite électrode décélératrice avant d'atteindre ledit échantillon.

13. Source d'ions selon l'une quelconque des revendications 10 à 12, caractérisée en ce qu'elle comporte en outre des moyens (26, 27) pour compenser tant la charge que le courant du faisceau d'ions positifs (f) sortant de ladite chambre d'ionisation (1) et arrivant dans une chambre de réaction (E) dans laquelle est placé ledit échantillon.

14. Source d'ions selon l'une quelconque des revendications précédentes, caractérisée en ce que ladite électrode de polarisation (4; $4_1$; $4_2$) est polarisée, par rapport à une desdites électrodes d'ionisation, par un générateur alternatif (29) dont la fréquence est très inférieure à ladite haute fréquence de ladite haute tension alternative.

15. Source d'ions selon l'une quelconque des revendications 1 à 13, caractérisée en ce que la troisième électrode (4; $4_1$; $4_2$) est polarisée, par rapport à l'une desdites électrodes d'ionisation, par une source de tension continue.

**Patentansprüche**

1. Ionenquelle im Bündel mit einer einzigen Kammer zur Ionisation und zur Bildung von plasma, mit zwei Ionisationselektroden (3 und 2; 2a; 3b), mit Mitteln (11, 13, 14, 15) zum Einspritzen wenigstens eines zu ionisierenden Gases in die Kammer, mit wenigstens einer Gasabzugsöffnung außerhalb der Kammer, mit gesteuerten Pumpmitteln zum Ansaugen von Gas außerhalb der Kammer durch die wenigstens eine Öffnung und mit Mitteln (6) zum Anlegen einer hohen Wechselspannung zwischen den zwei Ionisationselektroden mit einer hohen Frequenz, die ausreicht, um damit wenigstens ein in die Kammer eingespritztes Gas zu ionisieren und einplasma im Innenraum der Kammer zu erzeugen, dadurch gekennzeichnet,

daß die zwei Ionisationselektroden (3 und 2; 2a; 2b) unmagnetisch und in Kontakt mit dem in der Kammer (1) gebildeten plasma sind, wobei eine der zwei Ionisationselektroden, die als äußere Ionisationselektrode (3) bezeichnet wird, wenigstens einen Teil der Wand der Kammer bildet und wobei die andere der zwei Elektroden, die als innere Ionisationselektrode (2; 2a; 2b) bezeichnet wird, in der Kammer angeordnet ist; und gekennzeichnet durch:

eine Polarisationselektrode (4; $4_1$; $4_2$), die am Austrittsende der Ionen aus der Kammer angeordnet ist;

Mittel (9; 9a; 9b; 29) zum Anlegen einer Potentialdifferenz zwischen der Polarisationselektrode und einer der Ionisationselektroden, um die Polarisationselektrode unabhängig zu polarisieren; und

ein System von Permanentmagneten mit abwechselnden magnetischen polen (5; 5a) zur Bildung einer multipolaren oder vielspiegelartigen Magnetanordnung in unmittelbarer Nachbar-

schaft der äußeren Ionisationselektrode.

2. Ionenquelle nach Anspruch 1, dadurch gekennzeichnet, daß die hohe Frequenz der hohen Wechselspannung oberhalb von 20 kHz liegt.

3. Ionenquelle nach Anspruch 1 oder 2, dadurch gekennzeichnet, daß diese einen Kondensator (7) aufweist, der in Reihe mit den Mitteln zum Anlegen einer hohen Wechselspannung mit hoher Frequenz angeordnet ist, zwischen der äußeren und der inneren Ionisationselektrode.

4. Ionenquelle nach Anspruch 3, dadurch gekennzeichnet, daß diese zusätzlich in der Zuspeisung der inneren Ionisationselektrode (2) einen Impendanzadapterkreis (8) aufweist.

5. Ionenquelle nach einem der vorangehenden Ansprüche, dadurch gekennzeichnet daß die innere Ionisationselektrode (2) durch die Verbindung mehrerer Rohre (12) gebildet ist.

6. Ionenquelle nach Anspruch 5, dadurch gekennzeichnet, daß die Mittel (11, 13, 14, 15) zum Einspritzen von zu ionisierendem Gas in die Kammer das Gas in die Rohre (12) einspritzen.

7. Ionenquelle nach einem der Ansprüche 1 bis 4, dadurch gekennzeichnet, daß die innere Ionisationselektrode (2a) eben ist.

8. Ionenquelle nach einem der Ansprüche 1 bis 4, dadurch gekennzeichnet, daß die äußere Ionisationselektrode (2b) konkav ist, wobei ihre Konkavität gegen die polarisationselektrode (4; $4_1$; $4_2$) gerichtet ist.

9. Ionenquelle nach einem der vorangehenden Ansprüche zur Bildung einer Quelle des Typs "Ionenquelle in Plasma", dadurch gekennzeichnet, daß die Polarisationselektrode ($4_1$) eine volle Zielscheibe mit Türmuster ist, mit Ausnahme von eventuellen Gasaustrittsöffnungen (4b), und daß die Zielscheibe zum Verschließen der Ionenaustrittsöffnung der Ionisationskammer (1) und das Muster zum Beschießen durch die Ionen, welche gegen die Zielscheiben im Inneren der Ionisationskammer gerichtet sind, angeordnet ist.

10. Ionenquelle nach einem der Ansprüche 1 bis 8 zur Bildung einer "Ionenquelle im Bündel", dadurch gekennzeichnet, daß die polarisationselektrode ($4_2$) ein Ionenemissionsgitter ist das dazu geeignet ist die Ionen des Plasmas vom Inneren der Ionsationskammer passieren zu lassen, wobei das Muster zum Bechließen durch dei Ionen in einer von der Ionisationskammer (1) unabhängigen Reaktionskammer (E) angeordnet ist.

11. Ionenquelle nach Anspruch 10, dadurch gekennzeichnet, daß diese außerdem Mittel zur Beschleunigung der Ionen aufweist, die durch das Ionenemissionsgitter ($4_2$) hindurchtreten, um ein gegen das Muster gerichtetes Bündel zu erzeugen.

12. Ionenquelle nach Anspruch 11, dadurch gekennzeichnet, daß die Mittel zur Beschleunigung der Ionen von einem Beschleunigungsgitter (20) und einem Verzögerungsgitter (21) gebildet sind, wobei die Ionen schließlich durch die Verzögerungselektrode hindurchtreten, bevor sie das Muster erreichen.

13. Ionenquelle nach einem der Ansprüche 10 bis 12, dadurch gekennzeichnet, daß es außerdem Mittel (26, 27) zur Kompensierung aufweist, solange die Ladung des Bündelstromes der positiven Ionen (f) aus der Ionisationskammer (1) austritt und in einer Reaktionskammer (E) ankommt, in welcher das Muster angeordnet ist.

14. Ionenquelle nach einem der vorangehenden Ansprüche, dadurch gekennzeichnet, daß die Polarisationselektrode (4; $4_1$; $4_2$) im Verhältnis zu einer der Ionisationselektroden durch einen Wechselgenerator (29) polarisiert ist, dessen Frequenz wesentlich unterhalb der hohen Frequenz der hohen Wechselspannung liegt.

15. Ionenquelle nach einem der Ansprüche 1 bis 13, dadurch gekennzeichnet, daß die dritte Elektrode (4; $4_1$; $4_2$) im Verhältnis zu einer der Ionisationselektroden durch eine kontinuierliche Spannungsquelle polarisiert ist.

**Claims**

1. Ion source in the form of a beam comprising a single ionization and plasma formation chamber, with two ionization electrodes (3 and 2; 2a; 2b), means (11, 13, 14, 15) for injecting into said chamber at least one gas to be ionized, at least one orifice for removing gas from said chamber, pumping means (P) controlled for sucking gas from said chamber through at least one orifice and means (6) for applying between said two ionization electrodes a high frequency alternating voltage sufficient for ionizing said at least one gas injected into said chamber and for creating a plasma inside said chamber; characterized in that:

the two ionization electrodes (3 and 2; 2a; 2b) are amagnetic and in contact with the plasma formed in said chamber (1), one of said two ionization electrodes, called outer ionization electrode (3), forming at least a part of the wall of said chamber, the other of these two electrodes, called inner ionization electrode (2; 2a; 2b), being disposed in said chamber; and in that it comprises:

a biasing electrode (4; $4_1$; $4_2$) disposed at the end of said chamber from which the ions are removed;

means (9; 9a; 9b; 29) for applying a potential difference between said biasing electrode and one of said ionization electrodes, in order to bias said biasing electrode independently; and

a system of permanent magnets with alternating magnetic poles (5; 5a) for creating a magnetic configuration of the multipole or multi-mirror type in the immediate vicinity of said outer ionization electrode.

2. Ion source according to claim 1, characterized in that the high frequency of said high alternating voltage is greater than 20 kHz.

3. Ion source according to claim 1 or 2, characterized in that it comprises a capacitor (7) disposed in series with said means for applying a high frequency high alternating voltage between said outer and inner ionization electrodes.

4. Ion source according to claim 3, characterized in that it further comprises, in the power supply for the inner ionization electrode (2), an impedance matching circuit (8).

5. Ion source according to any one of the preceding claims, characterized in that said inner ionization electrode (2) is formed by the association of several tubes (12).

6. Ion source according to claim 5, characterized in that the means (11, 13, 14, 15) for injecting the gas to be ionized into said chamber inject the gas in these tubes (12).

7. Ion source according to any one of claims 1 to 4, characterized in that said inner ionization electrode (2a) is flat.

8. Ion source according to any one of claims 1 to 4, characterized in that said outer ionization electrode (2b) is concave, its concavity being directed towards said biasing electrode (4; $4_1$; $4_2$).

9. Ion source according to any one of the preceding claims for forming a source of the "plasma ion source" type modified in that said biasing electrode ($4_1$) is a solid sample holder target, except possibly for gas discharge holes (4b), and in that said target is disposed so as to close said end of said ionization chamber (1) from which the ions are removed, the sample to be bombarded by said ions being applied against said target inside said ionization chamber.

10. Ion source according to any one of claims 1 to 8, for forming a "beam ion source", characterized in that said biasing electrode ($4_2$) is an ion emission grid adapted for letting the ions of the plasma pass from inside said ionization chamber, the sample to be bombarded by the ions being placed in a reaction chamber (E) independent of the ionization chamber (1).

11. Ion source according to claim 10, characterized in that it further comprises means for accelerating the ions passing through said ion emission grid ($4_2$) so as to form a beam directed towards said sample.

12. Ion source according to claim 11, characterized in that said means for accelerating the ions are formed by an accelerating grid (20) and a decelerating grid (21), the ions escaping finally through said decelerating electrode before reaching said sample.

13. Ion source according to any one of claims 10 to 12, characterized in that it further comprises means (26, 27) for compensating not only the charge but also the current of the beam with positive ions (f) leaving said ionization chamber (1) and arriving in a reaction chamber (E) in which said sample is placed.

14. Ion source according to any one of the preceding claims, characterized in that said biasing electrode (4; $4_1$; $4_2$) is biased with respect to one of said ionization electrodes, by an AC generator (29) whose frequency is very much less than said high frequency of said high AC voltage.

15. Ion source according to any one of claims 1 to 13, characterized in that the third electrode (4; $4_1$; $4_2$) is biased, with respect to said ionization electrodes, by a DC voltage source.

FIG.1.

FIG.3.

FIG.2.

FIG.4.

FIG.5.

FIG.6.

2a

30

7

4

6

3 5

29

5

2a

4

1

5a

3

FIG.7.

5

5a

$f_1$

2b

4

$f_1$

3

FIG.8

# FIG. 9.

a {
| N | | N | | N | | N | | N | |
| S | | S | | S | | S | | S | |
| N | | N | | N | | N | | N | |

b {
| N | N | N | N | N | N | N | N |
| S | S | S | S | S | S | S | S |
| N | N | N | N | N | N | N | N |

# FIG.10.

4

FIG.11.

FIG.12.